# EUROPEAN PATENT APPLICATION

(11) **EP 4 790 908 A1**
(43) Date of publication of application: **12.08.2026**
(21) Application number: 24874874.1
(22) Date of filing: 10.09.2024
(51) Int. Cl.: H04B 1/40, H04B 1/04, H04B 1/18, H03K 17/693, H03K 17/687, H02M 1/00, H04B 1/44

(54) **RF SWITCHING CIRCUIT AND ELECTRONIC DEVICE INCLUDING SAME**

(30) Priority: 06.10.2023 KR 20230133833; 05.12.2023 KR 20230174985
(71) Applicant: Samsung Electronics Co., Ltd., Suwon-si, Gyeonggi-do 16677 (KR)
(72) Inventor: KIM, Seonjun, Suwon-si Gyeonggi-do 16677 (KR); YANG, Dongil, Suwon-si Gyeonggi-do 16677 (KR); SEONG, Kihyug, Suwon-si Gyeonggi-do 16677 (KR); NA, Hyoseok, Suwon-si Gyeonggi-do 16677 (KR); MOON, Yohan, Suwon-si Gyeonggi-do 16677 (KR)
(74) Representative: HGF
(86) International application number: PCT/KR2024/013682
(87) International publication number: WO 2025/075316

(57) **Abstract**

In embodiments, an electronic device is provided. The electronic device may comprise: a processor; a radio frequency (RF) transceiver; a radio frequency front end (RFFE) circuit; an antenna; an RF switching circuit for impedance tuning of the antenna; and a power supply circuit for the RF switching circuit. The RF switching circuit may comprise: a coupler connected to an RF common port; a plurality of transistor circuits connected to the coupler and for a plurality of RF ports; a voltage supply circuit configured to provide a voltage to each transistor circuit of the plurality of transistor circuits to selectively electrically connect one of the plurality of RF ports to the RF common port; and a converter circuit connected to the coupler and configured to convert an RF signal into a direct current (DC) signal.

## Description

### [Technical Field]

Embodiments of the present disclosure relate to a radio frequency (RF) switching circuit and an electronic device including the RF switching circuit.

### [Background Art]

An electronic device may transmit or receive a signal using an antenna. The electronic device may include various radio frequency (RF) components for processing the signal. For example, the electronic device may include a radio frequency front end (RFFE) circuit. For example, the electronic device may include an RF switching circuit to selectively connect a specific element to an RF path or to select a specific RF path for processing the signal.

The above-described information may be provided as a related art for the purpose of helping understanding of the present disclosure. No argument or decision is made as to whether any of the above description may be applied as a prior art related to the present disclosure.

### [Disclosure]

### [Technical Solution]

In embodiments, a radio frequency (RF) switching circuit is provided. The RF switching circuit may comprise an RF common port, a plurality of RF ports including a first RF port and a second RF port, a plurality of transistor circuits including a first transistor circuit for the first RF port and a second transistor circuit for the second RF port, a voltage supply circuit configured to provide a voltage to the plurality of transistor circuits to connect electrically the RF common port to one of the plurality of RF ports selectively, a coupler connected to the RF common port, and a converter circuit configured to convert an RF signal obtained from the coupler into a direct current (DC) signal having a negative voltage. The voltage supply circuit may be configured to obtain a power signal having a positive voltage from a power supply circuit and obtain the DC signal having the negative voltage. The voltage supply circuit may be configured to provide a first voltage corresponding to the power signal and a second voltage corresponding to the DC signal to each transistor circuit of the plurality of transistor circuits.

In embodiments, an electronic device is provided. The electronic device may comprise a processor, a radio frequency (RF) transceiver, a radio frequency front end (RFFE) circuit, an antenna, an RF switching circuit for impedance tuning of the antenna, and a power supply circuit for the RF switching circuit. The RF switching circuit may include a coupler connected to an RF common port, a plurality of transistor circuits for a plurality of RF ports, connected to the coupler, a voltage supply circuit configured to provide a voltage to each transistor circuit of the plurality of transistor circuits to connect electrically the RF common port to one of the plurality of RF ports selectively, and a converter circuit connected to the coupler and configured to convert an RF signal into a direct current (DC) signal.

### [Description of the Drawings]

FIG. 1 is a block diagram of an electronic device in a network environment according to various embodiments of the present invention.
FIGS. 2A, 2B, and 2C illustrate an example of an electronic device including a radio frequency (RF) switching circuit according to various embodiments of the present invention.
FIG. 3 illustrates an example of a functional configuration of an RF switching circuit according to various embodiments of the present invention.
FIG. 4 illustrates examples of a component of a switching operation circuit according to various embodiments of the present invention.
FIG. 5 illustrates an example of an RF switching circuit for generating a negative voltage through RF-direct current (DC) conversion according to various embodiments of the present invention.
FIG. 6 illustrates examples of a component of a transistor circuit of a switching operation circuit according to various embodiments of the present invention.
FIG. 7 illustrates an example of a transistor circuit of a switching operation circuit according to various embodiments of the present invention.

### [Mode for Invention]

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.

In various embodiments of the present disclosure described below, a hardware approach will be described as an example. However, since the various embodiments of the present disclosure include technology that uses both hardware and software, the various embodiments of the present disclosure do not exclude a software-based approach.

A term referring to a part of an electronic device (e.g., a substrate, a printed circuit board (PCB), a flexible PCB (FPCB), a module, an antenna, an element, a circuit, a processor, a chip, a component, or a device), a term referring to a semiconductor (e.g., a transistor, a field effect transistor (FET), a metal-oxide-semiconductor FET (MOSFET), a junction FET (JFET), or a semiconductor circuit), a term referring to a circuit (e.g., a PCB, an FPCB, a signal line, a feeding line, a data line, an RF signal line, an antenna line, an RF path, an RF module, an RF circuit, a splitter, a divider, a coupler, or a combiner) and the like used in the following descriptions are exemplified for convenience of description. Therefore, the present disclosure is not limited to terms to be described below, and another term having an equivalent technical meaning may be used. In addition, a term such as '...unit', '...device', '...object', and '...structure', and the like used below may mean at least one shape structure or may mean a unit processing a function.

In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.

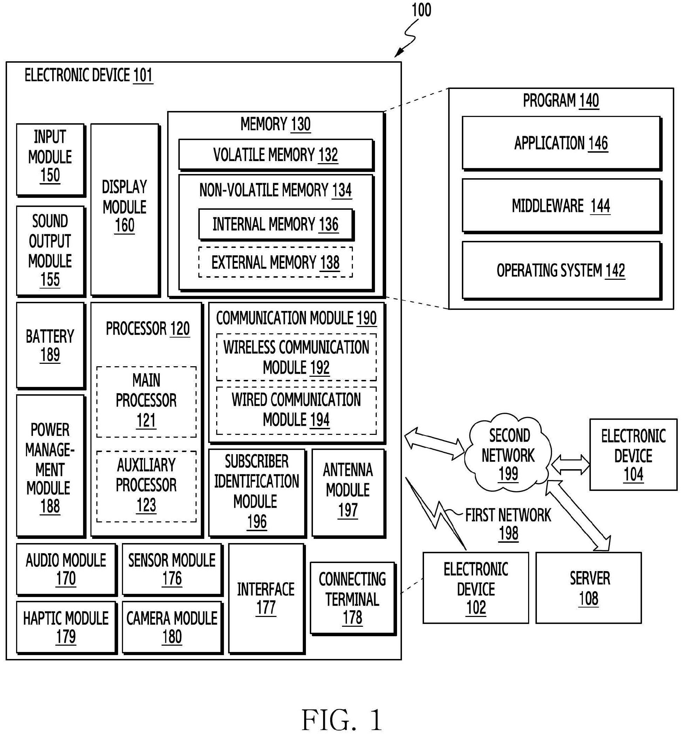

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

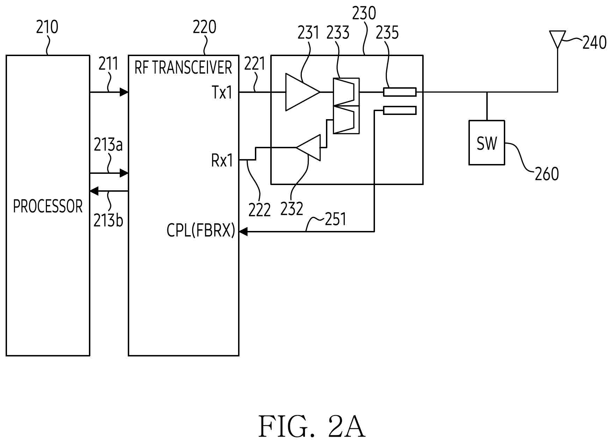

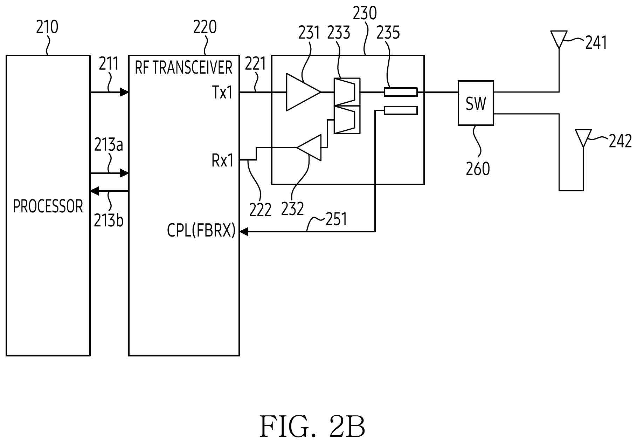

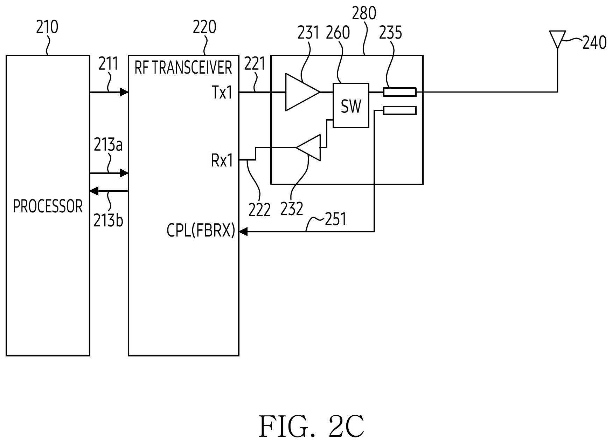

FIGS. 2A, 2B, and 2C illustrate an example of an electronic device including a radio frequency (RF) switching circuit according to various embodiments of the present invention.

Referring to FIG. 2A, an electronic device 101 may include a processor 210, an RF transceiver 220 (e.g., an RFIC), a radio frequency front end (RFFE) module 230, and an antenna 240. The electronic device 101 may include the processor 210. For example, the processor 210 may include at least one of an application processor (AP) (e.g., the main processor 121 of FIG. 1) or a communication processor (CP) (e.g., the auxiliary processor 123 of FIG. 1). For example, the processor 210 may include the AP and the CP. For example, the processor may include the AP. For example, the processor 210 may include the CP. The processor 210 may control the RF transceiver 220 through a control interface 211. For example, the processor 210 may generate a baseband signal. The processor 210 may control the RF transceiver 220 to process the generated baseband signal. The processor 210 may transmit a signal 213a (e.g., analog data or digital data). The processor 210 may control the RF transceiver 220 such that the signal is transmitted through the antenna 240. The processor 210 may receive a signal 213b (e.g., analog data or digital data).

The electronic device 101 may include the RF transceiver 220. For example, the RF transceiver 220 may be implemented as a single chip (e.g., an RFIC chip) or as a portion of a single package. The RF transceiver 220 may provide an RF signal to the RFFE module 230 through a path 221. The RF transceiver 220 may include an analog to digital converter (ADC) for converting an analog signal into a digital signal. The RF transceiver 220 may include a mixer and an oscillator (e.g., a local oscillator (LO)) for down-conversion. The RF transceiver 220 may convert an RF signal received from the antenna 240 into a baseband signal to be processed by the processor 210. The RF transceiver 220 may include one or more transmission ports. The RF transceiver 220 may receive an RF signal from the RFFE module 230 through a path 222. The RF transceiver 220 may include a digital to analog converter (DAC) for converting a digital signal into an analog signal. The RF transceiver 220 may include a mixer and an oscillator for up-conversion. The RF transceiver 220 may convert the baseband signal generated by the processor 210 into an RF signal. The RF transceiver 220 may include one or more reception ports. The RF transceiver 220 may receive a feedback signal provided from a component (e.g., a coupler 235) of the RFFE module 230 electrically connected to the antenna 240. For example, the RF transceiver 220 may include a feedback receive port (FBRX) for the feedback signal. The coupler 235 may be electrically connected to the FBRX through a feedback path 251. The RF transceiver 220 may control at least a portion of a modulator or the RFFE module 230 through a mobile industry processor interface (MIPI) interface.

The electronic device 101 may include the RFFE module 230. The RFFE module 230 may be configured to transmit a transmission signal from the RF transceiver 220 to the antenna 240. The RFFE module 230 may include a power amplifier (PA) 231, a duplexer 233, and/or the coupler 235 for a transmission path. The coupler 235 may provide, to the RF transceiver 220 through the feedback path 251, a signal obtained through coupling with a signal delivered to the antenna 240 (hereinafter, a feedback signal). An RF signal generated by the RF transceiver 220 may be radiated into the air through the antenna 240 via the transmission path. The RFFE module 230 may transmit a reception signal from the antenna 240 to the RF transceiver 220. For example, the RFFE module 230 may include, in addition to components for the transmission path, components for a reception path. The RFFE module 230 may include a low noise amplifier (LNA) 232 for the reception path. As an example, in a frequency band of a frequency division duplex (FDD), an RF path may be branched into a transmission path (e.g., the path 221) and a reception path (e.g., the path 222) through the duplexer 233 of the RFFE module 230.

According to an embodiment, the electronic device 101 may include an RF switching circuit 260 connected to a path between the RFFE module 230 and the antenna 240. For example, the RF switching circuit 260 may be a single pole n-throw (SPnT) switch (e.g., a single pole double throw (SPDT) or a single pole four throw (SP4T)). The RF switching circuit 260 may be used for impedance tuning (or which may be referred to as impedance matching). Impedance tuning indicates a technique for reducing power loss by adjusting an impedance of a load to correspond to an impedance of a circuit. The RF switching circuit 260 may be connected to a plurality of passive elements (e.g., an inductor, a capacitor, and a resistor). For example, RF output ports of the RF switching circuit 260 may be connected to each of the plurality of passive elements. Each passive element of the plurality of passive elements may be connected to a ground. The RF switching circuit 260 may electrically connect one of the plurality of passive elements to the path. As an example, based on control of the processor 210 or the RF transceiver 220, the RF switching circuit 260 may connect one of the plurality of passive elements to the path such that an impedance of an antenna load is close to a characteristic impedance.

Referring to FIG. 2B, an electronic device 101 may include a processor 210, an RF transceiver 220, an RFFE module 230, a first antenna 241, and a second antenna 242. In order to describe components and operations of the processor 210, the RF transceiver 220, and the RFFE module 230, the descriptions of FIG. 2A may be referred to.

According to an embodiment, the electronic device 101 may include an RF switching circuit 260 connected to the first antenna 241 and the second antenna 242. For example, the RF switching circuit 260 may be an SPDT. The RF switching circuit 260 may be configured to connect the first antenna 241 or the second antenna 242 to the RFFE module 230 based on control of the processor 210 or the RF transceiver 220. For example, the electronic device 101 may transmit, through the first antenna 241 or through the second antenna 242, a transmission signal of a frequency band of a duplexer 233. The electronic device 101 may use one of a first transmission path for transmitting a signal through the first antenna 241 and a second transmission path for transmitting a signal through the second antenna 242. The electronic device 101 may be configured to, through the RF switching circuit 260 connected to the RFFE module 230, electrically connect one of the first transmission path or the second transmission path to the RFFE module 230 selectively.

Referring to FIG. 2C, an electronic device 101 may include a processor 210, an RF transceiver 220, an RFFE module 280, and an antenna 240. In order to describe components and operations of the processor 210, the RF transceiver 220, the RFFE module 280, and the antenna 240, the descriptions of FIG. 2A may be referred to.

According to an embodiment, the RFFE module 230 may include a PA 231, an LNA 232, an RF switching circuit 260, and/or a coupler 235. For example, the RFFE module 280 may support a time division duplex (TDD) frequency band. Since the TDD frequency band has the same transmission frequency band and reception frequency band, the RFFE module 280 may include the RF switching circuit 260 instead of a duplexer 233. For example, the RF switching circuit 260 may be an SPDT. An RF common (RFC) port of the RF switching circuit 260 may be electrically connected to the antenna 240. The RF common port may be a port corresponding to a pole in the SPDT. A first RF port of the RF switching circuit 260 may be connected to a transmission path for the PA 231, and a second RF port of the RF switching circuit 260 may be connected to a reception path for the LNA 232. Based on control of the processor 210 or the RF transceiver 220, the RF switching circuit 260 may electrically connect, to the antenna 240, the transmission path for the PA 231 or the reception path for the LNA 232, selectively.

In FIGS. 2A to 2C, examples in which an RF switching circuit according to embodiments of the present disclosure is used have been described, but embodiments of the present disclosure are not limited to the above-described examples. In addition to the examples of FIGS. 2A to 2C, the RF switching circuit 260 may be used as a component for passing or blocking an RF signal.

A switch applied to an RF circuit (hereinafter, an RF switch) may include a plurality of transistors for a switching operation of an RF path. In order to secure linearity and isolation of a transistor, a negative voltage may be applied to a gate and/or a body of some transistors. For example, in order to activate a specific RF path, a positive voltage may be applied to a gate of a field effect transistor (FET) on the specific RF path. If a negative voltage is applied to a body of the FET while the positive voltage is applied to the gate of the FET, occurrence of leakage current may be reduced due to reverse bias between a source-substrate and between a drain-substrate. In addition, for example, if a positive voltage is applied, in a shunt FET disposed in parallel to a specific RF path, in a situation in which a '0' bias is applied to a gate, to the gate due to an RF signal, an FET channel may be activated. For an inactive state of the FET channel of the shunt FET, a negative voltage may be applied to the gate of the shunt FET.

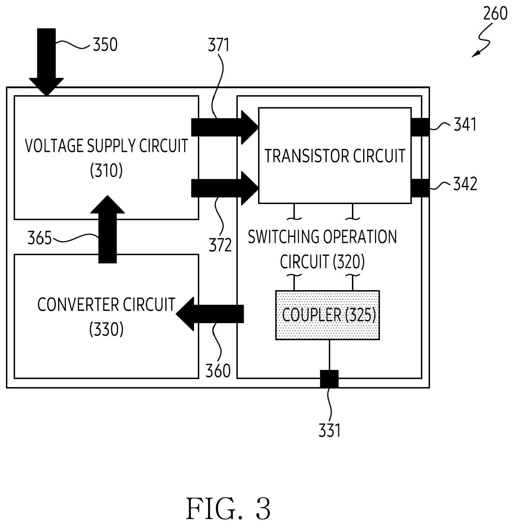

The RF switching circuit may use, for the above-described switching operation, not only a positive voltage but also a negative voltage. A method of converting a positive voltage obtained from a power supply circuit (e.g., a power management integrated circuit (PMIC)) into a negative voltage through a charge-pump circuit may be considered, but due to the charge-pump circuit, a size of a switch may increase and a design may become complicated. Therefore, in embodiments of the present disclosure, an RF switching circuit configured to generate a negative voltage used for a switching operation of a transistor without the charge-pump circuit is proposed. Hereinafter, through FIGS. 3 to 5, components of the RF switching circuit for generating the negative voltage are described.

FIG. 3 illustrates an example of a functional configuration of an RF switching circuit (e.g., an RF switching circuit 260) according to various embodiments of the present invention.

Referring to FIG. 3, the RF switching circuit 260 may include a voltage supply circuit 310, a switching operation circuit 320, and a converter circuit 330. The switching operation circuit 320 may include an RF common (RFC) port 331, a first RF port 341, and a second RF port 342 in order to form an RF path in the RF switching circuit 260. The RF common port 331 may be electrically connected to one of the first RF port 341 or the second RF port 342. In FIG. 3, an SPDT is illustrated as an example of the RF switching circuit 260, but embodiments of the present disclosure are not limited thereto. As an example, in order to implement an SP4T, additional RF ports may be disposed in an RF switching circuit.

The voltage supply circuit 310 may provide a voltage to the switching operation circuit 320. The voltage supply circuit 310 may obtain a power signal 350 from an external component (e.g., a power supply circuit or a PMIC) of the RF switching circuit 260. The power signal 350 may have a positive voltage for driving the RF switching circuit 260. The voltage supply circuit 310 may use, for linearity and/or isolation of a transistor, a negative voltage in addition to the positive voltage. The voltage supply circuit 310 may obtain a DC signal 365 having a negative voltage from the converter circuit 330. The voltage supply circuit 310 may provide, to the switching operation circuit 320, a first voltage 371 corresponding to the power signal 350 and a second voltage 372 corresponding to the DC signal 365. For example, the voltage supply circuit 310 may provide, to the switching operation circuit 320, a voltage of the obtained signal as it is without separate voltage level conversion. The voltage supply circuit 310 may provide, to the switching operation circuit 320, the positive voltage of the power signal 350 as the first voltage 371. The voltage supply circuit 310 may provide, to the switching operation circuit 320, the negative voltage of the DC signal 365 as the second voltage 372. For another example, the voltage supply circuit 310 may include a level shifter. The level shifter may generate the first voltage 371 having the positive voltage by changing a voltage level of the power signal 350. The level shifter may generate the second voltage 372 having the negative voltage by changing a voltage level of the DC signal 365. The voltage supply circuit 310 may provide the first voltage 371 and the second voltage 372 to the switching operation circuit 320.

The switching operation circuit 320 may include a transistor circuit for switching for each RF port. The first voltage 371 and the second voltage 372 may be used for activation or blocking of a transistor circuit in the switching operation circuit 320. According to a connection mode of the RF switching circuit 260, it may be determined which path of a transistor circuit is activated and which path of a transistor circuit is blocked. As an example, a positive voltage (e.g., the first voltage 371) may be applied to a gate of an FET on a path of a transistor circuit to be activated. As an example, a negative voltage (e.g., the second voltage 372) may be applied to a gate of an FET on a path of a transistor circuit to be deactivated. The switching operation circuit 320 may include a coupler 325. The coupler 325 may pass an RF signal input to the RF common port 331. The passed RF signal may be provided to each transistor circuit of the switching operation circuit 320. The RF signal may be delivered to an RF port (e.g., the first RF port 371 or the second RF port 372) through the activated transistor circuit. The coupler 325 may couple the RF signal input to the RF common port 331. The coupler 325 may be used to provide at least a portion of an RF signal (e.g., an RF signal 360) to the converter circuit 330. The coupled RF signal 360 may be provided to the converter circuit 330. In the present disclosure, a transistor circuit may indicate a circuit configured with one or more transistors, and may be referred to, in addition to the transistor circuit, as an FET circuit, an FET stack circuit, stacked FETs, a semiconductor circuit, a stack FET, a series FET, a series FET circuit, and a shunt FET circuit, and/or an equivalent technical term.

The converter circuit 330 may obtain the RF signal 360 from the coupler 325 of the switching operation circuit 320. The converter circuit 330 may convert the RF signal 360 into the DC signal 365. The converter circuit 330 may convert the RF signal 360 into the DC signal 365 based on RF-DC conversion (or alternating current (AC)-DC conversion). According to an embodiment, the converter circuit 330 may be configured to rectify a negative component of a waveform of the RF signal 360 in order to generate the DC signal 365 having the negative voltage. The converter circuit 330 may generate the signal 365 having the negative voltage by rectifying a signal during a cycle in which the waveform of the RF signal 360 has the negative component. As an example, the converter circuit 330 may include a rectifier diode configured to allow a negative component to flow. The converter circuit 330 may be configured to transmit the DC signal 365 to the voltage supply circuit 310. In the present disclosure, the converter circuit 330 may indicate a circuit configured to perform RF-DC conversion. The RF-DC conversion may be referred to, in addition to the RF-DC conversion, as AC-DC conversion, variable voltage-fixed voltage, RF-negative voltage conversion, and/or an equivalent technical term. In addition, in implementing the RF-DC conversion, the conversion may include an operation in which an RF signal having a waveform obtains a substantially fixed voltage magnitude (e.g., including that which may have a voltage value within a threshold range having a ripple) through a capacitor and a rectifier (e.g., a diode).

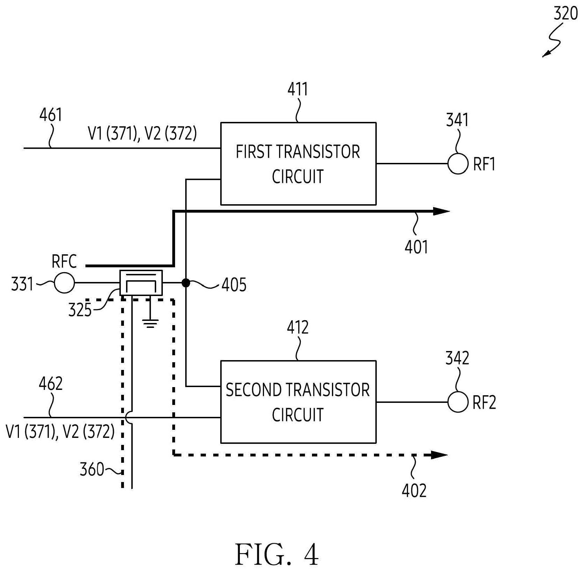

FIG. 4 illustrates examples of a component of a switching operation circuit (e.g., a switching operation circuit 320) according to various embodiments of the present invention. As an example of an RF switching circuit 260, an SPDT is illustrated, but embodiments of the present disclosure are not limited thereto. As an example, in order to implement an SP4T, additional RF ports and transistor circuits may be included in an RF switching circuit. The same reference numerals may be used for the same description.

Referring to FIG. 4, the switching operation circuit 320 may include a coupler 325 for extracting an RF signal 360. The coupler 325 may include an input port connected to an RF common port 331, a pass-through port connected to an input terminal 405 of transistor circuits, and a coupling port for feedback. The coupler 325 may obtain the RF signal 360 coupled from an RF signal obtained through the RF common port 331. The coupler 325 may output the RF signal 360 through the coupling port.

The switching operation circuit 320 may include a first transistor circuit 411 for a first RF port 341. The first transistor circuit 411 may obtain a voltage (e.g., a first voltage 371 and/or a second voltage 372) from a voltage supply circuit 310 through a first voltage path 461. The first transistor circuit 411 may electrically connect the RF common port 331 and the first RF port 341 based on the voltage (e.g., the first voltage 371 and/or the second voltage 372) from the voltage supply circuit 310. For example, the first transistor circuit 411 may include FETs arranged in series between the RF common port 331 and the first RF port 341. As an example, the FETs may be stacked FETs. For an electrical connection between the RF common port 331 and the first RF port 341 of the RF switching circuit 260, the switching operation circuit 320 may activate a transistor circuit (e.g., the first transistor circuit 411) between the RF common port 331 and the first RF port 341 and block another transistor circuit (e.g., a second transistor circuit). Activation or blocking of a transistor circuit may be performed based on the first voltage 371 and the second voltage 372.

The switching operation circuit 320 may include a second transistor circuit 412 for a second RF port 342. The second transistor circuit 412 may obtain a voltage (e.g., the first voltage 371 and/or the second voltage 372) from the voltage supply circuit 310 through a second voltage path 462. The second transistor circuit 412 may electrically connect the RF common port 331 and the second RF port 342 based on the voltage (e.g., the first voltage 371 and/or the second voltage 372) from the voltage supply circuit 310. For example, the second transistor circuit 412 may include FETs arranged in series between the RF common port 331 and the second RF port 342. As an example, the FETs may be stack FETs. For an electrical connection between the RF common port 331 and the second RF port 342 of the RF switching circuit 260, the switching operation circuit 320 may activate a transistor circuit (e.g., the second transistor circuit 412) between the RF common port 331 and the second RF port 342 and block another transistor circuit (e.g., the first transistor circuit). Activation or blocking of the transistor circuit may be performed based on the first voltage 371 and the second voltage 372.

In a first connection mode 401, an electronic device 101 may electrically connect the RF common port 331 and the first RF port 341. The processor 210 may control, in the first connection mode 401, the RF switching circuit 260 to connect the RF common port 331 to the first RF port 341. In the first connection mode 401, a positive voltage (e.g., the first voltage 371) may be applied to gates of the FETs of the first transistor circuit 411. While the positive voltage (e.g., the first voltage 371) is applied to the gates of the FETs of the first transistor circuit 411, a negative voltage (e.g., the second voltage 372) may be applied to a body (e.g., a substrate) of the FETs. As the negative voltage is applied to the body, a threshold voltage may increase and leakage current may decrease. In the first connection mode 401, while the positive voltage (e.g., the first voltage 371) is applied to the gates of the FETs of the first transistor circuit 411, a negative voltage (e.g., the second voltage 372) may be applied to gates of the FETs of the second transistor circuit 412. In order to block the electrical connection between the RF common port 331 and the second RF port 342 due to the RF signal, the negative voltage (e.g., the second voltage 372) may be applied to the gates of the FETs of the second transistor circuit 412.

In a second connection mode 402, the electronic device 101 may electrically connect the RF common port 331 and the second RF port 342. The processor 210 may control, in the second connection mode 402, the RF switching circuit 260 to connect the RF common port 331 to the second RF port 342. In the second connection mode 402, a positive voltage (e.g., the first voltage 371) may be applied to the gates of the FETs of the second transistor circuit 412. While the positive voltage (e.g., the first voltage 371) is applied to the gates of the FETs of the second transistor circuit 412, a negative voltage (e.g., the second voltage 372) may be applied to a body (e.g., a substrate) of the FETs. As the negative voltage is applied to the body, a threshold voltage may increase and leakage current may decrease. In the second connection mode 402, while the positive voltage (e.g., the first voltage 371) is applied to the gates of the FETs of the second transistor circuit 412, a negative voltage (e.g., the second voltage 372) may be applied to the gates of the FETs of the first transistor circuit 411. In order to block the electrical connection between the RF common port 331 and the first RF port 341 due to the RF signal, the negative voltage (e.g., the second voltage 372) may be applied to the gates of the FETs of the first transistor circuit 411.

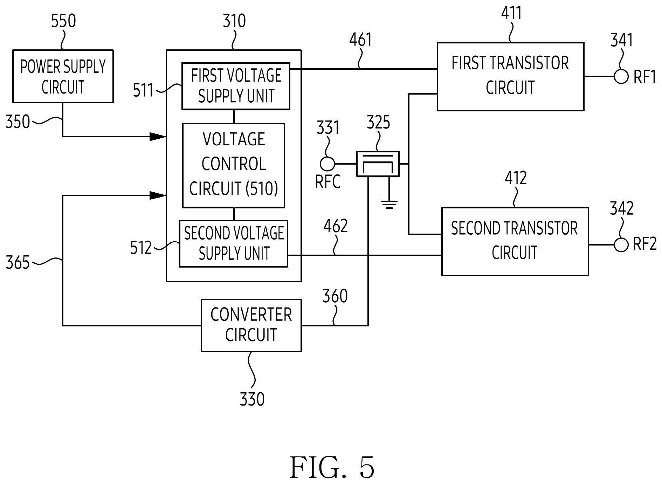

FIG. 5 illustrates an example of an RF switching circuit (e.g., an RF switching circuit 260) for generating a negative voltage through RF-direct current (DC) conversion according to various embodiments of the present invention. As an example of the RF switching circuit 260, an SPDT is illustrated, but embodiments of the present disclosure are not limited thereto. As an example, in order to implement an SP4T, additional RF ports and transistor circuits may be included in an RF switching circuit. The same reference numerals may be used for the same description.

Referring to FIG. 5, the RF switching circuit 260 may obtain a power signal 350 from a power supply circuit 550. The power signal 350 may have a positive voltage. A voltage supply circuit 310 may obtain a DC signal 365 from a converter circuit 330. The DC signal 365 may have a negative voltage. The voltage supply circuit 310 of the RF switching circuit 260 may include a voltage control circuit 510, a first voltage supply unit 511, and a second voltage supply unit 512. The first voltage supply unit 511 may provide, through a first voltage path 461, a voltage to be applied to a gate of an FET in a first transistor circuit 411 and/or a voltage to be applied to a body of the FET in the first transistor circuit 411. The second voltage supply unit 512 may provide, through a second voltage path 462, a voltage to be applied to a gate of an FET in a second transistor circuit 412 and/or a voltage to be applied to a body of the FET in the second transistor circuit 412. The voltage control circuit 510 may provide a first voltage 371 corresponding to the power signal 350 to the first voltage supply unit 511 and the second voltage supply unit 512. The voltage control circuit 510 may provide a second voltage 372 corresponding to the DC signal 365 to the first voltage supply unit 511 and the second voltage supply unit 512. For example, the voltage control circuit 510 may provide, to each of the first voltage supply unit 511 and the second voltage supply unit 512, the positive voltage of the power signal 350 as the first voltage 371. The voltage control circuit 510 may provide, to each of the first voltage supply unit 511 and the second voltage supply unit 512, the negative voltage of the DC signal 365 as the second voltage 372. For another example, the voltage control circuit 510 may be a level shifter. The level shifter may generate the first voltage 371 having a positive voltage by changing a voltage level of the power signal 350. The level shifter may generate the second voltage 372 having a negative voltage by changing a voltage level of the DC signal 365. The voltage control circuit 510 may provide the first voltage 371 and the second voltage 372 to each of the first voltage supply unit 511 and the second voltage supply unit 512. In various embodiments of the present disclosure, the level shifter includes a circuit device configured to convert, adjust, and/or control a voltage level and/or use the voltage level as it is, and may be referred to, in addition to the level shifter, as a voltage providing circuit, a voltage level shifting circuit, a level shifter, a level shifting circuit, a level converter, a voltage level converter, a voltage level conversion circuit, and/or an equivalent technical term.

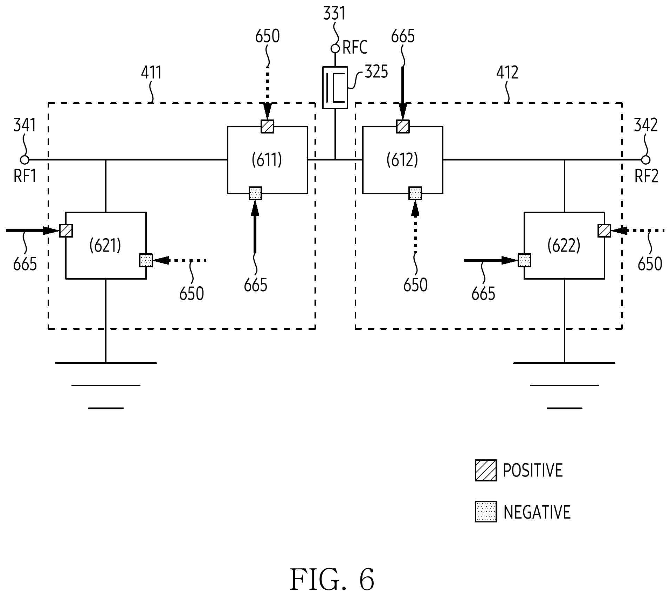

The RF switching circuit 260 may include a coupler 325 and the converter circuit 330, which is a feedback circuit from the coupler 325, in order to generate a negative voltage. The converter circuit 330 may convert the RF signal 360 obtained from the coupler 325 into the DC signal 365. The DC signal 365 may have the negative voltage. The second voltage 372 corresponding to the DC signal 365 may also have the negative voltage. As the negative voltage is applied to a body of an FET or a gate of the FET, linearity of transistors in the RF switching circuit 260 or isolation performance of an RF path of each RF port may be improved. Hereinafter, through FIGS. 6 to 7, examples in which the negative voltage is used for linearity and/or isolation are described.

FIG. 6 illustrates examples of a component of a transistor circuit (e.g., a first transistor circuit 411 or a second transistor circuit 412) of a switching operation circuit (e.g., a switching operation circuit 320) according to various embodiments of the present invention. As an example of the RF switching circuit 260, an SPDT is illustrated, but embodiments of the present disclosure are not limited thereto. As an example, in order to implement an SP4T, additional RF ports and transistor circuits may be included in an RF switching circuit. The same reference numerals may be used for the same description.

Referring to FIG. 6, an RF common port 331 may be connected to the first transistor circuit 411 and the second transistor circuit 412 through a coupler 325.

The first transistor circuit 411 may include a first series FET circuit 611 and a first shunt FET circuit 621. The first series FET circuit 611 may be used to control a current flow of an electrical path (hereinafter, a first RF path) between the RF common port 331 and a first RF port 341. The first series FET circuit 611 may include first FETs disposed in series on the first RF path. The first shunt FET circuit 621 may be used to protect damage due to a surge voltage and to control the current flow on the first RF path. The first shunt FET circuit 621 may be disposed in parallel on the first RF path. For example, the first shunt FET circuit 621 may include third FETs disposed in parallel on the first RF path.

The second transistor circuit 412 may include a second series FET circuit 612 and a second shunt FET circuit 622. The second series FET circuit 612 may be used to control a current flow of an electrical path (hereinafter, a second RF path) between the RF common port 331 and a second RF port 342. The second series FET circuit 612 may include second FETs disposed in series on the first RF path. The second shunt FET circuit 622 may be used to protect damage due to a surge voltage and to control the current flow on the second RF path. The second shunt FET circuit 622 may be disposed in parallel on the second RF path. For example, the second shunt FET circuit 622 may include fourth FETs disposed in parallel on the second RF path.

The first transistor circuit 411 may obtain, from the voltage supply circuit 310, a first voltage 650 having a positive voltage and a second voltage 665 having a negative voltage. The second transistor circuit 412 may obtain, from the voltage supply circuit 310, the first voltage 650 having the positive voltage and the second voltage 665 having the negative voltage. The first voltage 650 may be provided based on a power signal 350 from a power supply circuit (e.g., a power supply circuit 550). The second voltage 665 may be provided based on a DC signal 365 from the converter circuit 330. The first voltage 650 and the second voltage 665 may be applied to a gate and/or a body for a switching operation of FETs of the switching operation circuit 320.

In FIG. 6, a situation in which voltages are applied to the first series FET circuit 611, the first shunt FET circuit 621, the second series FET circuit 612, and/or the second shunt FET circuit 622 in a case that the RF common port 331 and the first RF port 341 are electrically connected is described. For example, in a case that the RF common port 331 and the first RF port 341 are electrically connected, the second voltage 665 having the negative voltage may be applied to a body of an FET of the first series FET circuit 611. As the negative voltage is applied to the body of the FET while the first voltage 650 having the positive voltage is applied to a gate of the FET, linearity of the FET may be improved.

For example, in a case that the RF common port 331 and the first RF port 341 are electrically connected, the second voltage 665 having the negative voltage may be applied to a gate of an FET of the second series FET circuit 612. As a negative voltage is applied to a gate of an FET on the second RF path different from the first RF path electrically connected, a channel of another path (e.g., the second RF path) other than the activated first RF path may be completely turned off, so that isolation performance may be improved. Additionally, in order to improve the isolation performance, the first voltage 650 having the positive voltage may be applied to a body of the FET.

For example, in a case that the RF common port 331 and the first RF port 341 are electrically connected, the second voltage 665 having the negative voltage may be applied to a gate of a shunt FET of the first shunt FET circuit 621. As the negative voltage is applied to the gate of the shunt FET, isolation performance may be improved. Additionally, in order to improve the isolation performance, the first voltage 650 having the positive voltage may be applied to a body of the FET.

For example, in a case that the RF common port 331 and the first RF port 341 are electrically connected, the second voltage 665 having the negative voltage may be applied to a body of a shunt FET of the second shunt FET circuit 622. In order to block an RF signal to the second RF port 342, the first voltage 650 having the positive voltage may be applied to a gate of the shunt FET of the second shunt FET circuit 622. As the negative voltage is applied to the body of the shunt FET while the first voltage 650 having the positive voltage is applied to the gate of the shunt FET, linearity of the shunt FET and isolation of the first RF path with respect to the second RF path may be improved.

In FIG. 6, a situation in which voltages are applied to the first series FET circuit 611, the first shunt FET circuit 621, the second series FET circuit 612, and/or the second shunt FET circuit 622 in a case that the RF common port 331 and the first RF port 341 are electrically connected has been described, but a technical principle described through FIG. 6 may be equally applied even in a case that the RF common port 331 and the second RF port 342 are electrically connected. For example, in a case that the RF common port 331 and the second RF port 342 are electrically connected, the second voltage 665 having the negative voltage may be applied to the body of the FET of the second series FET circuit 612. For example, in a case that the RF common port 331 and the second RF port 342 are electrically connected, the second voltage 665 having the negative voltage may be applied to the gate of the FET of the first series FET circuit 611. For example, in a case that the RF common port 331 and the second RF port 342 are electrically connected, the second voltage 665 having the negative voltage may be applied to the gate of the shunt FET of the second shunt FET circuit 622. For example, in a case that the RF common port 331 and the second RF port 342 are electrically connected, the second voltage 665 having the negative voltage may be applied to the body of the shunt FET of the first shunt FET circuit 621.

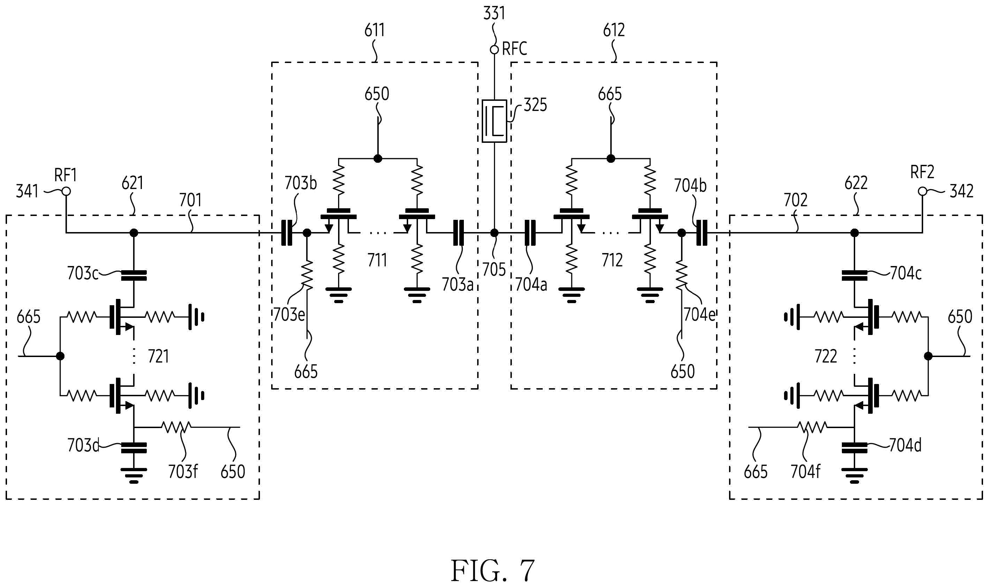

FIG. 7 illustrates an example of a transistor circuit (e.g., a first transistor circuit 411 and a second transistor circuit 412) of a switching operation circuit (e.g., a switching operation circuit 320) according to various embodiments of the present invention. As an example of an RF switching circuit 260, an SPDT is illustrated, but embodiments of the present disclosure are not limited thereto. As an example, in order to implement an SP4T, additional RF ports and transistor circuits may be included in an RF switching circuit. The same reference numerals may be used for the same description.

Referring to FIG. 7, an electronic device 101 may electrically connect an RF common port 331 and a first RF port 341. A processor 210 may control the RF switching circuit 260 to connect the RF common port 331 to the first RF port 341 in a first connection mode (e.g., a first connection mode 401).

A first series FET circuit 611 may include a plurality of first FETs 711. A drain terminal of a starting FET of the plurality of first FETs 711 may be connected to an input terminal 705 through a capacitor 703a. A source terminal of a last FET of the plurality of first FETs 711 may be connected to the first RF port 341 through a capacitor 703b. As a first voltage 650 having a positive voltage is applied to gates of the plurality of first FETs 711, a current may flow on a first RF path 701. A second voltage 665 having a negative voltage may be applied to a load 703e connected to the source terminal. Through the load 703e, a negative voltage may be applied to a body (e.g., a substrate of a stack FET) of the plurality of first FETs 711. As the second voltage 665 having the negative voltage is applied to the body while the first voltage 650 is applied to the gates of the plurality of first FETs 711, linearity of the FET may increase. A first shunt FET circuit 621 may include a plurality of third FETs 721. A drain terminal of a starting FET of the plurality of third FETs 721 may be connected to the first RF path 701 through a capacitor 703c. A source terminal of a last FET of the plurality of third FETs 721 may be connected to a ground through a capacitor 703d. The second voltage 665 having the negative voltage may be applied to gates of the plurality of third FETs 721 such that the current flowing on the first RF path 701 does not flow into the first shunt FET circuit 621 connected in parallel. In addition, the first voltage 650 having the positive voltage may be applied to a load 703f connected to the source terminal. Through the load 703f, the positive voltage may be applied to a body (e.g., a substrate of a stack FET) of the plurality of third FETs 721.

A second series FET circuit 612 may include a plurality of second FETs 712. A drain terminal of a starting FET of the plurality of second FETs 712 may be connected to the input terminal 705 through a capacitor 704a. A source terminal of a last FET of the plurality of second FETs 712 may be connected to a second RF port 342 through a capacitor 704b. As the second voltage 665 having the negative voltage is applied to gates of the plurality of second FETs 712, a current may not flow on a second RF path 702. The first voltage 650 having the positive voltage may be applied to a load 704e connected to the source terminal. Through the load 704e, a negative voltage may be applied to a body (e.g., a substrate of a stack FET) of the plurality of second FETs 712. As the first voltage 650 having the positive voltage is applied to the body while the second voltage 665 is applied to the gates of the plurality of second FETs 712, linearity of the FET may increase. A second shunt FET circuit 622 may include a plurality of fourth FETs 722. A drain terminal of a starting FET of the plurality of fourth FETs 722 may be connected to the second RF path 702 through a capacitor 704c. A source terminal of a last FET of the plurality of fourth FETs 722 may be connected to a ground through a capacitor 704d. The first voltage 650 having the positive voltage may be applied to gates of the plurality of fourth FETs 722, such that a current does not flow into the second RF port 342 and flows to the second shunt FET circuit 622 connected in parallel even if the current flows on the second RF path 702. In addition, the second voltage 665 having the negative voltage may be applied to a load 704f connected to the source terminal. Through the load 704f, the negative voltage may be applied to a body (e.g., a substrate of a stack FET) of the plurality of fourth FETs 722.

In order to compare a magnitude of a negative voltage obtained through DC conversion of an RF signal 360 and a voltage for an operation of an FET (e.g., a threshold voltage), output power of an RF signal passing through a coupler 325 may be used. A magnitude of a voltage applied to FETs according to the output power of the RF signal may be determined based on he following equations.${P}_{out} = 10 * log \left({P}_{watt}\right) + 30$

The Pₒᵤₜ indicates output power in a dBm unit, and the P_{watt} indicates output power in a Watt unit.${P}_{watt} = {10}^{\left(Pout/10\right)} * 0.001 = {{V}_{RMS}}^{2} / {Z}_{0}$

The Z₀ indicates a load impedance, and the V_{RMS} indicates an RMS voltage magnitude.${V}_{PEAK} = {\left(2*{Z}_{0}*{P}_{watt}\right)}^{0.5}$

The V_{PEAK} indicates a maximum voltage magnitude.${V}_{pp} = {V}_{PEAK} * 2$

The Vₚₚ indicates twice the maximum voltage magnitude.${V}_{max} = {V}_{PP} / 2 * \left[1+\frac{VSWR - 1}{VSWR + 1}\right]$

The Vₘₐₓ indicates a magnitude of a voltage applied to an FET circuit according to a voltage standing wave ratio (VSWR) and the Pₒᵤₜ. For example, when it is assumed that a characteristic impedance (Z₀) is approximately 50 ohms, a relationship of a voltage magnitude according to an output of the RF signal may be determined based on the following table.

**[Table 1]**

| Pout [dBm] | Pwatt [W] | Vpeak [V] | Vpp [V] | VSWR | Vmax [V] |
|---|---|---|---|---|---|
| 24 | 0.251 | 5.012 | 10.024 | 30.000 | 9.700 |
| 14 | 0.025 | 1.585 | 3.170 | 2.000 | 2.113 |
| 15 | 0.032 | 1.778 | 3.557 | 30.000 | 3.442 |
| 5 | 0.003 | 0.562 | 1.125 | 2.000 | 0.750 |
| 34 | 2.512 | 15.849 | 31.698 | 10.000 | 28.816 |
| 35 | 3.162 | 17.783 | 35.566 | 10.000 | 32.332 |
| 36 | 3.981 | 19.953 | 39.905 | 10.000 | 36.277 |
| 37 | 5.012 | 22.387 | 44.774 | 10.000 | 40.704 |
| 38 | 6.310 | 25.119 | 50.238 | 10.000 | 45.671 |
| 39 | 7.943 | 28.184 | 56.368 | 10.000 | 51.243 |
| 40 | 10.000 | 31.623 | 63.246 | 10.000 | 57.496 |
| 41 | 12.589 | 35.481 | 70.963 | 10.000 | 64.512 |
| 42 | 15.849 | 39.811 | 79.621 | 10.000 | 72.383 |
| 43 | 19.953 | 44.668 | 89.337 | 10.000 | 81.215 |
| 44 | 25.119 | 50.119 | 100.237 | 10.000 | 91.125 |
| 45 | 31.623 | 56.234 | 112.468 | 10.000 | 102.244 |
| 46 | 39.811 | 63.096 | 126.191 | 10.000 | 114.720 |
| 47 | 50.119 | 70.795 | 141.589 | 10.000 | 128.717 |

For example, the output power of the RF signal passing through the coupler 325 may be 24 dBm. The first series FET circuit 611 may include five first FETs 711. The second series FET circuit 612 may include five second FETs 712. The first FETs 711 and the second FETs 712 may be stacked. For example, a voltage applied to the second FETs 712 may be approximately 9.7 V. Approximately 1.94 V may be applied to each FET by an RF signal. Meanwhile, the coupler 325 may extract the RF signal 360 based on the RF signal and convert the extracted RF signal 360 into the DC signal 365. For example, when it is assumed that a coupling factor of the coupler 325 is approximately 10 dB, a magnitude of the RF signal 360 may be approximately 14 dBm. A magnitude of a negative voltage of the DC signal 365 may be approximately -2 V. When it is assumed that a turn-on voltage of an FET is 0.7 V, an FET (e.g., an FET of the second series FET circuit 712) of the second RF path 702 may be turned on due to an RF signal passing through a coupler. In order to prevent such turn-on, a negative voltage (e.g., approximately -2 V) may be applied to a gate of the FET. As the negative voltage is applied to the gate, the FET of the second RF path 702 may be turned off. A current does not flow on the second RF path 702, so that isolation performance of the first RF path 701 may be improved.

For example, the output power of the RF signal passing through the coupler 325 may be 15 dBm. A voltage applied to the second FETs 712 may be approximately 3.5 V. Approximately 0.7 V may be applied to each FET by an RF signal. Meanwhile, the coupler 325 may extract the RF signal 360 based on the RF signal and convert the extracted RF signal 360 into the DC signal 365. For example, when it is assumed that the coupling factor is approximately 10 dB, the magnitude of the RF signal 360 may be approximately 5 dBm. The magnitude of the negative voltage of the DC signal 365 may be approximately -0.75 V. When it is assumed that a turn-on voltage of an FET is 0.7 V, the FET (e.g., the FET of the second series FET circuit 712) of the second RF path 702 may be turned on due to the RF signal passing through the coupler. In order to prevent such turn-on, a negative voltage (e.g., approximately -0.75 V) may be applied to the gate of the FET. As the negative voltage is applied to the gate, the FET of the second RF path 702 may be turned off. A current does not flow on the second RF path 702, so that the isolation performance of the first RF path 701 may be improved.

In FIG. 7, a situation in which voltages are applied to the first series FET circuit 611, the first shunt FET circuit 621, the second series FET circuit 612, and/or the second shunt FET circuit 622 in a case that the RF common port 331 and the first RF port 341 are electrically connected has been described, but a technical principle described through FIG. 7 may be equally applied even in a case that the RF common port 331 and the second RF port 342 are electrically connected.

In embodiments, a radio frequency (RF) switching circuit 260 is provided. The RF switching circuit 260 may comprise an RF common port 331, a plurality of RF ports including a first RF port 341 and a second RF port 342, a plurality of transistor circuits including a first transistor circuit 441 for the first RF port 341 and a second transistor circuit 442 for the second RF port 342, a voltage supply circuit 310 configured to provide a voltage to the plurality of transistor circuits to connect electrically the RF common port 331 to one of the plurality of RF ports selectively, a coupler 325 connected to the RF common port 331, and a converter circuit 330 configured to convert an RF signal obtained from the coupler 325 into a direct current (DC) signal 365 having a negative voltage. The voltage supply circuit 310 may be configured to obtain a power signal 350 having a positive voltage from a power supply circuit 550 and obtain the DC signal 365 having the negative voltage. The voltage supply circuit 310 may be configured to provide a first voltage 371 or 650 corresponding to the power signal 350 and a second voltage 372 or 665 corresponding to the DC signal 365 to each transistor circuit of the plurality of transistor circuits.

According to an embodiment, the voltage supply circuit 310 may be configured to, in a first connection mode for electrically connecting the RF common port 331 and the first RF port 341, apply the first voltage 371 or 650 to each gate of at least one first field effect transistor (FET) of the first transistor circuit 441 and apply the second voltage 372 or 665 to each gate of at least one second FET of the second transistor circuit 442. The voltage supply circuit 310 may be configured to, in a second connection mode for electrically connecting the RF common port 331 and the second RF port 342, apply the second voltage 372 or 665 to each gate of at least one first FET of the first transistor circuit 441 and apply the first voltage 371 or 650 to each gate of at least one second FET of the second transistor circuit 442.

According to an embodiment, the converter circuit 330 may be configured to obtain the RF signal from the coupler 325. The converter circuit 330 may be configured to generate the DC signal 365 having the negative voltage by rectifying negative components of a waveform of the RF signal.

According to an embodiment, an input port of the coupler 325 may be connected to the RF common port 331. A pass-through port of the coupler 325 may be connected to an input terminal of the plurality of transistor circuits for receiving the RF signal of the RF common port 331. A coupling port of the coupler 325 may be connected to the converter circuit 330.

According to an embodiment, the voltage supply circuit 310 may include a level shifter configured to generate the first voltage 371 or 650 by adjusting a voltage level of the positive voltage and to generate the second voltage 372 or 665 by adjusting a voltage level of the negative voltage. The level shifter may be configured to obtain the positive voltage from the power supply circuit 550 and to obtain the negative voltage from the converter circuit 330.

According to an embodiment, the voltage supply circuit 310 may be connected to the power supply circuit 550 for providing the positive voltage without a charge pump circuit for DC-DC conversion. The voltage supply circuit 310 may be connected to the converter circuit 330 for providing the negative voltage through alternating current (AC)-DC conversion, which is different from the DC-DC conversion.

According to an embodiment, the first transistor circuit 441 may include a first series field effect transistor (FET) circuit connecting the RF common port 331 and the first RF port 341. The second transistor circuit 442 may include a second series FET circuit connecting the RF common port 331 and the second RF port 342. The RF common port 331 may be connected to a first drain terminal of the first series FET circuit and a second drain terminal of the second series FET circuit through the coupler 325.

According to an embodiment, the first series FET circuit may be configured to electrically connect the RF common port 331 and the first RF port 341 based on the first voltage 371 or 650 and the second voltage 372 or 665 in a first connection mode. The second series FET circuit may be configured to electrically connect the RF common port 331 and the second RF port 342 based on the first voltage 371 or 650 and the second voltage 372 or 665 in a second connection mode.

According to an embodiment, the voltage supply circuit 310 may be configured to, in the first connection mode, while the first voltage 371 or 650 is applied to first gates of first FETs of the first series FET circuit, apply the second voltage 372 or 665 to a first body terminal of the first FETs. The voltage supply circuit 310 may be configured to, in the first connection mode, while the second voltage 372 or 665 is applied to second gates of second FETs of the second series FET circuit, apply the first voltage 371 or 650 to a second body terminal of the second FETs.

According to an embodiment, the voltage supply circuit 310 may be configured to, in the second connection mode, while the second voltage 372 or 665 is applied to first gates of first FETs of the first series FET circuit, apply the first voltage 371 or 650 to a first body terminal of the first FETs. The voltage supply circuit 310 may be configured to, in the second connection mode, while the first voltage 371 or 650 is applied to second gates of second FETs of the second series FET circuit, apply the second voltage 372 or 665 to a second body terminal of the second FETs.

According to an embodiment, the first transistor circuit 441 may include a first shunt FET circuit connected in parallel to the first RF port 341 and the first series FET circuit. The second transistor circuit 442 may include a second shunt FET circuit connected in parallel to the second RF port 342 and the second series FET circuit. The voltage supply circuit 310 may be configured to, in the first connection mode, apply the second voltage 372 or 665 to third gates of third FETs of the first shunt FET circuit and apply the first voltage 371 or 650 to fourth gates of fourth FETs of the second shunt FET circuit. The voltage supply circuit 310 may be configured to, in the second connection mode, apply the first voltage 371 or 650 to third gates of third FETs of the first shunt FET circuit and apply the second voltage 372 or 665 to fourth gates of fourth FETs of the second shunt FET circuit.

According to an embodiment, the voltage supply circuit 310 may be configured to, while the second voltage 372 or 665 is applied to the third gates of the third FETs in the first connection mode, apply the first voltage 371 or 650 to a third body terminal of the third FETs. The voltage supply circuit 310 may be configured to, while the first voltage 371 or 650 is applied to the fourth gates of the fourth FETs in the first connection mode, apply the second voltage 372 or 665 to a fourth body terminal of the fourth FETs.

According to an embodiment, the voltage supply circuit 310 may be configured to, while the first voltage 371 or 650 is applied to the third gates of the third FETs in the second connection mode, apply the second voltage 372 or 665 to a third body terminal of the third FETs. The voltage supply circuit 310 may be configured to, while the second voltage 372 or 665 is applied to the fourth gates of the fourth FETs in the second connection mode, apply the first voltage 371 or 650 to a fourth body terminal of the fourth FETs.

According to an embodiment, the coupler 325 may be disposed between the RF common port 331 and the input terminal of the plurality of transistor circuits. The plurality of RF ports may include a third RF port and a fourth RF port. The plurality of transistor circuits may include a third transistor circuit connecting the third RF port and the input terminal and a fourth transistor circuit connecting the fourth RF port and the input terminal.

According to an embodiment, the voltage supply circuit 310 may be configured to, in a first connection mode for connecting the first RF port 341 and the RF common port 331, apply the first voltage 371 or 650 to gates of the first transistor circuit 441 and apply the second voltage 372 or 665 to gates of the second transistor circuit 442, the third transistor circuit, and the fourth transistor circuit. The voltage supply circuit 310 may be configured to, in a second connection mode for connecting the second RF port 342 and the RF common port 331, apply the first voltage 371 or 650 to gates of the second transistor circuit 442 and apply the second voltage 372 or 665 to gates of the first transistor circuit 441, the third transistor circuit, and the fourth transistor circuit. The voltage supply circuit 310 may be configured to, in a third connection mode for connecting the third RF port and the RF common port 331, apply the first voltage 371 or 650 to gates of the third transistor circuit and apply the second voltage 372 or 665 to gates of the first transistor circuit 441, the second transistor circuit 442, and the fourth transistor circuit. The voltage supply circuit 310 may be configured to, in a fourth connection mode for connecting the fourth RF port and the RF common port 331, apply the first voltage 371 or 650 to gates of the fourth transistor circuit and apply the second voltage 372 or 665 to gates of the first transistor circuit 441, the second transistor circuit 442, and the third transistor circuit.

In embodiments, an electronic device 101 is provided. The electronic device 101 may include a processor 210, a radio frequency (RF) transceiver 220, a radio frequency front end (RFFE) circuit 230, an antenna 240, an RF switching circuit 260 for impedance tuning of the antenna, and a power supply circuit 550 for the RF switching circuit 260. The RF switching circuit 260 may include a coupler 325 connected to an RF common port 331, a plurality of transistor circuits for a plurality of RF ports, connected to the coupler 325, a voltage supply circuit 310 configured to provide a voltage to each transistor circuit of the plurality of transistor circuits to connect electrically the RF common port 331 to one of the plurality of RF ports selectively, and a converter circuit 330 connected to the coupler 325 and configured to convert an RF signal into a direct current (DC) signal 365.

According to an embodiment, the converter circuit 330 may be configured to convert the RF signal obtained from the coupler 325 into the DC signal 365 having a negative voltage. The voltage supply circuit 310 may be configured to generate a first voltage 371 or 650 of a positive voltage based on a power signal 350 obtained from the power supply circuit 550, and the voltage supply circuit 310 may be configured to generate a second voltage 372 or 665 of the negative voltage based on the DC signal 365 obtained from the converter circuit 330. The voltage supply circuit 310 may be configured to provide the first voltage 371 or 650 and the second voltage 372 or 665 to each transistor circuit of the plurality of transistor circuits.

According to an embodiment, the plurality of RF ports may include a first RF port 341 and a second RF port 342. The plurality of transistor circuits may include a first transistor circuit 441 for the first RF port 341 and a second transistor circuit 442 for the second RF port 342. The first RF port 341 may be electrically connected to a first passive element. The second RF port 342 may be electrically connected to a second passive element.

According to an embodiment, the voltage supply circuit 310 may be configured to, in a first connection mode for electrically connecting the RF common port 331 and the first RF port 341, apply the first voltage 371 or 650 to each gate of at least one first field effect transistor (FET) of the first transistor circuit 441 and apply the second voltage 372 or 665 to each gate of at least one second FET of the second transistor circuit 442. The voltage supply circuit 310 may be configured to, in a second connection mode for electrically connecting the RF common port 331 and the second RF port 342, apply the second voltage 372 or 665 to each gate of at least one first FET of the first transistor circuit 441 and apply the first voltage 371 or 650 to each gate of at least one second FET of the second transistor circuit 442.

According to an embodiment, the voltage supply circuit 310 may be connected to the power supply circuit 550 for providing the positive voltage without a charge pump circuit for DC-DC conversion. The voltage supply circuit 310 may be connected to the converter circuit 330 for providing the negative voltage through alternating current (AC)-DC conversion, which is different from the DC-DC conversion.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device, comprising:
a processor;
a radio frequency (RF) transceiver;
a radio frequency front end (RFFE) circuit;
an antenna;
an RF switching circuit for impedance tuning of the antenna; and
a power supply circuit for the RF switching circuit,
wherein the RF switching circuit includes:
a coupler connected to an RF common port,
a plurality of transistor circuits for a plurality of RF ports, connected to the coupler;
a voltage supply circuit configured to provide a voltage to each transistor circuit of the plurality of transistor circuits to connect electrically the RF common port to one of the plurality of RF ports selectively; and
a converter circuit connected to the coupler and configured to convert an RF signal into a direct current (DC) signal.

2. The electronic device of claim 1,
wherein the converter circuit is configured to convert the RF signal obtained from the coupler into the DC signal with a negative voltage, and
wherein the voltage supply circuit is configured to:
generate a first voltage of a positive voltage based on a power signal obtained from the power supply circuit,
generate a second voltage of the negative voltage based on the DC signal obtained from the converter circuit, and
provide the first voltage and the second voltage to each transistor circuit of the plurality of transistor circuits.

3. The electronic device of claim 2,
wherein the plurality of RF ports include a first RF port and a second RF port;
wherein the plurality of transistor circuits include a first transistor circuit for the first RF port and a second transistor circuit for the second RF port,
wherein the first RF port is electrically connected to a first passive element, and
wherein the second RF port is electrically connected to a second passive element.

4. The electronic device of claim 3,
wherein the voltage supply circuit is configured to:
apply, in a first connection mode for electrically connecting the RF common port and the first RF port, the first voltage to each gate of at least one first field effect transistor (FET) of the first transistor circuit and the second voltage to each gate of at least one second FET of the second transistor circuit, and
apply, in a second connection mode for electrically connecting the RF common port and the second RF port, the second voltage to each gate of at least one first FET of the first transistor circuit and the first voltage to each gate of at least one second FET of the second transistor circuit.

5. The electronic device of claim 4,
wherein the voltage supply circuit is connected to the power supply circuit for providing the positive voltage without a charge pump circuit for DC-DC conversion, and
wherein the voltage supply circuit is connected to the converter circuit for providing the negative voltage through alternating current (AC)-DC conversion, which is different from the DC-DC conversion.

6. A radio frequency (RF) switching circuit, comprising:
an RF common port;
a plurality of RF ports including a first RF port and a second RF port;
a plurality of transistor circuits including a first transistor circuit for the first RF port and a second transistor circuit for the second RF port;
a voltage supply circuit configured to provide a voltage to the plurality of transistor circuits to connect electrically the RF common port to one of the plurality of RF ports selectively;
a coupler connected to the RF common port; and
a converter circuit configured to convert an RF signal obtained from the coupler into a direct current (DC) signal having a negative voltage,
wherein the voltage supply circuit is configured to:
obtain a power signal having a positive voltage from a power supply circuit and obtain the DC signal having the negative voltage, and
provide a first voltage corresponding to the power signal and a second voltage corresponding to the DC signal to each transistor circuit of the plurality of transistor circuits.

7. The RF switching circuit of the claim 6,
wherein the voltage supply circuit is configured to:
apply, in a first connection mode for electrically connecting the RF common port and the first RF port, the first voltage to each gate of at least one first field effect transistor (FET) of the first transistor circuit and the second voltage to each gate of at least one second FET of the second transistor circuit, and
apply, in a second connection mode for electrically connecting the RF common port and the second RF port, the second voltage to each gate of at least one first FET of the first transistor circuit and the first voltage to each gate of at least one second FET of the second transistor circuit.

8. The RF switching circuit of the claim 7,
wherein the converter circuit is configured to:
obtain the RF signal from the coupler, and
generate the DC signal having the negative voltage by rectifying negative components of a waveform of the RF signal.

9. The RF switching circuit of the claim 6,
wherein an input port of the coupler is connected to the RF common port,
wherein a pass-through port of the coupler is connected to an input terminal of the plurality of transistor circuits for receiving the RF signal of the RF common port, and
wherein a coupling port of the coupler is connected to the converter circuit.

10. The RF switching circuit of the claim 6,
wherein the voltage supply circuit includes a level shifter configured to generate the first voltage by adjusting a voltage level of the positive voltage and to generate the second voltage by adjusting a voltage level of the negative voltage, and
wherein the level shifter is configured to obtain the positive voltage from the power supply circuit and to obtain the negative voltage from the converter circuit.

11. The RF switching circuit of the claim 6,
wherein the voltage supply circuit is connected to the power supply circuit for providing the positive voltage without a charge pump circuit for DC-DC conversion, and
wherein the voltage supply circuit is connected to the converter circuit for providing the negative voltage through alternating current (AC)-DC conversion, which is different from the DC-DC conversion.

12. The RF switching circuit of the claim 6,
wherein the first transistor circuit includes a first series field effect transistor (FET) circuit connecting the RF common port and the first RF port,
wherein the second transistor circuit includes a second series FET circuit connecting the RF common port and the second RF port, and
wherein the RF common port is connected to a first drain terminal of the first series FET circuit and a second drain terminal of the second series FET circuit through the coupler.

13. The RF switching circuit of the claim 12,
wherein the first series FET circuit is configured to electrically connect the RF common port and the first RF port based on the first voltage and the second voltage in a first connection mode, and
wherein the second series FET circuit is configured to electrically connect the RF common port and the second RF port based on the first voltage and the second voltage in a second connection mode.

14. The RF switching circuit of the claim 6,
wherein the coupler is disposed between the RF common port and the input terminal of the plurality of transistor circuits,
wherein the plurality of RF ports further include a third RF port and a fourth RF port, and
wherein the plurality of transistor circuits further include a third transistor circuit connected between the third RF port and the input terminal and a fourth transistor circuit connected between the fourth RF port and the input terminal.

15. The RF switching circuit of the claim 14,
wherein the voltage supply circuit is configured to:
apply, in a first connection mode for connecting the first RF port and the RF common port, the first voltage to gates of the first transistor circuit and the second voltage to gates of the second transistor circuit, the third transistor circuit, and the fourth transistor circuit,
apply, in a second connection mode for connecting the second RF port and the RF common port, the first voltage to gates of the second transistor circuit and the second voltage to gates of the first transistor circuit, the third transistor circuit, and the fourth transistor circuit,
apply, in a third connection mode for connecting the third RF port and the RF common port, the first voltage to gates of the third transistor circuit and the second voltage to gates of the first transistor circuit, the second transistor circuit, and the fourth transistor circuit, and
apply, in a fourth connection mode for connecting the fourth RF port and the RF common port, the first voltage to gates of the fourth transistor circuit and the second voltage to gates of the first transistor circuit, the second transistor circuit, the third transistor circuit.
